# EUROPEAN PATENT SPECIFICATION

(11) **EP 2 280 421 B1**
(45) Date of publication and mention of the grant of the patent: **04.04.2012**
(21) Application number: 09425303.6
(22) Date of filing: 29.07.2009
(51) Int. Cl.: H01L 31/052

(54) **Solar receiver for a solar concentrator with a linear focus**
Solarempfänger für einen Solarkonzentrator mit einem linearen Brennwinkel
Récepteur solaire pour concentrateur solaire doté d'une mise au point linéaire

(43) Date of publication of application: 02.02.2011
(73) Proprietor: Thesan S.p.A., 10129 Torino (IT)
(72) Inventor: Balbo di Vinadio, Aimone, 10050 Chiusa San Michele (Torino) (IT); Palazzetti, Mario, 10050 Chiusa San Michele (Torino) (IT)
(74) Representative: Marchitelli, Mauro

(56) References cited:
- WO-A-2007/084517
- WO-A-2009/090843
- US-A- 4 385 430
- US-A- 5 498 297
- ANDREEV V M ET AL: "Development of PV receivers for space line-focus concentrator modules" 19960513; 19960513 - 19960517, 13 May 1996 (1996-05-13), pages 341-344, XP010208160

## Description

### Background of the invention

The present invention relates in general to the production of energy by means of concentration of solar radiation on photovoltaic or solar receivers.

In solar concentration systems it is desirable to obtain a high concentration of solar energy both for increasing the efficiency and the yield of the solar concentration system and, in the case of photovoltaic systems, for reducing the amount of photovoltaic material.

### Description of the prior art

To increase the efficiency of solar concentration systems it is necessary to carry out a pointing of the concentrators both according to the zenithal direction and according to the azimuthal direction. The document No. WO 2005/116534 describes a solar concentrator comprising one or more concave mirrors that are mounted rotatably on a supporting structure about a horizontal axis and are driven by a first motor for changing their zenithal angle, in which the concave mirrors concentrate the solar radiation in the direction of one or more receivers that are fixed with respect to the concave mirrors. The supporting structure is orientable about a vertical axis by means of a second motor designed to adjust the azimuthal angle of the concave mirrors.

The solution described in the document No. WO 2005/116534 is affected by a wide range of drawbacks. A first drawback is that the concentration of solar energy that can be obtained depends exclusively upon the size of the concave mirrors, and to obtain high levels of concentration it is necessary to employ mirrors with large surface. A second drawback of the known solution 2005/116534 is that to vary the azimuthal orientation it is necessary to turn the supporting structure of the generator about a vertical axis.

The publication of V. M. Andreev, et al. "Development of PV receivers for space line-focus concentrator modules" of 13 May 1996 discloses a solar receiver having the features of the preamble of claim 1.

### Summary of the invention

The object of the present invention is to provide a solar receiver that will enable the problems of the known art to be overcome. In particular, the object of the present invention is to provide a solar receiver that will enable high levels of concentration of solar radiation to be obtained. A further object of the present invention is to provide a solar receiver that will enable azimuthal tracking of the sun with a simple, compact, and inexpensive system that does not require vertical rotation of the concentrator.

According to the present invention, the above objects are achieved by a solar receiver having the characteristics forming the subject of Claim 1.

### Brief description of the drawings

The present invention will now be described in detail with reference to the attached drawings, which are provided purely by way of non-limiting example and in which:
- Figure 1 is a perspective view of a generator of solar energy, which uses a receiver according to the present invention;
- Figure 2 is a perspective view of the receiver indicated by the arrow II in Figure 1;
- Figure 3 is an exploded perspective view of the receiver of Figure 2;
- Figure 4 is a cross section according to the line IV-IV of Figure 2;
- Figure 5 is a cross section according to the line V-V of Figure 4; and
- Figure 6 is an enlarged detail of the part indicated by the arrow VI in Figure 1.

### Detailed description of a preferred embodiment

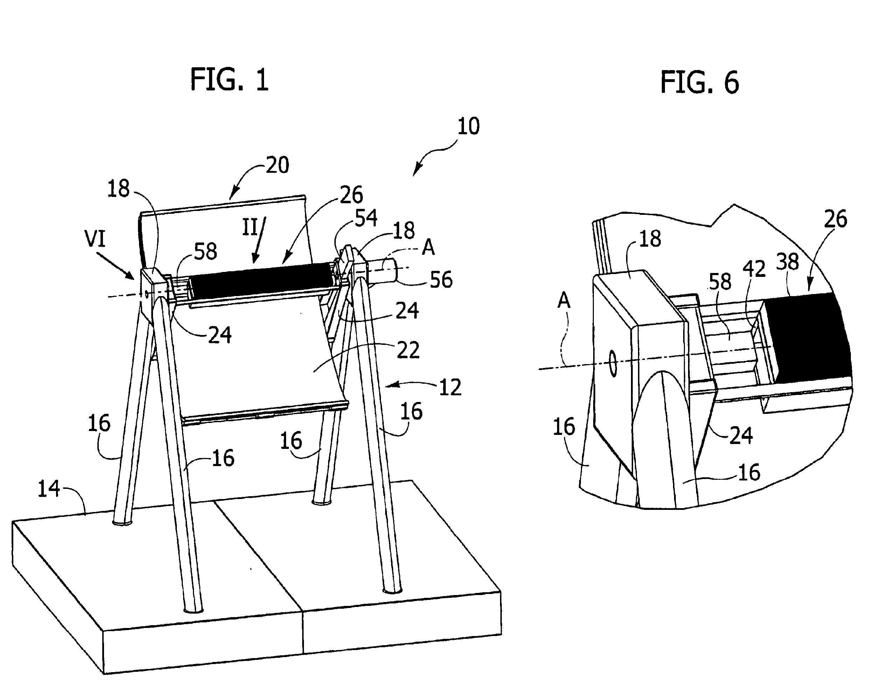

With reference to Figure 1, designated by 10 is a high-concentration solar-energy generator, which uses a solar receiver according to the present invention. The generator 10 comprises a supporting structure 12 fixed with respect to a stationary base 14. In the example illustrated in the figures, the supporting structure 12 comprises two triangular side supports, each of which is formed by two legs 16 converging upwards. The bottom ends of the legs 16 are fixed to the base 14. The top ends of each pair of legs 16 are fixed to a respective top support 18. The shape of the supporting structure 12 that is illustrated is not, however, binding and may vary according to the applications.

The supporting structure 12 carries a reflector 20, designed to concentrate the solar radiation on a focal line A. In the example illustrated in the figures, the reflector 20 comprises one or more mirrors with a reflecting surface 22 shaped like a parabolic cylinder. The focal axis of the reflecting surface 22 coincides with the focal line A. The reflector 20 is fixed to two side arms 24 that are articulated to the basic structure 12 about an axis of rotation coinciding with the focal axis A. The axis of rotation is defined by bearings (not illustrated) housed in the top supports 18. In the example illustrated in the figures, the focal axis A, which coincides with the axis of rotation of the reflector 20, is horizontal.

With reference to Figures 1 to 5, the generator 10 comprises a solar receiver 26 having an elongated shape and extending parallel to the focal line A.

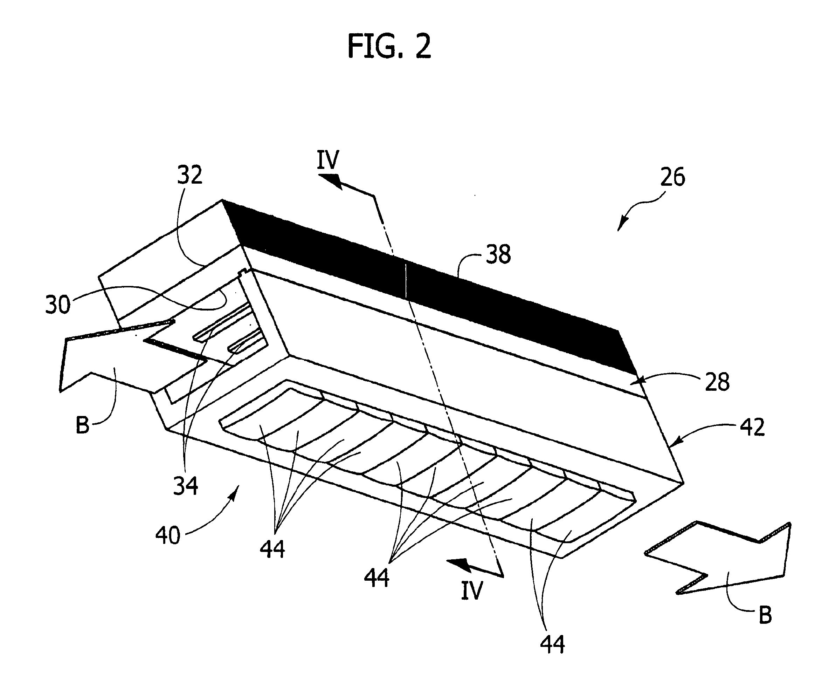

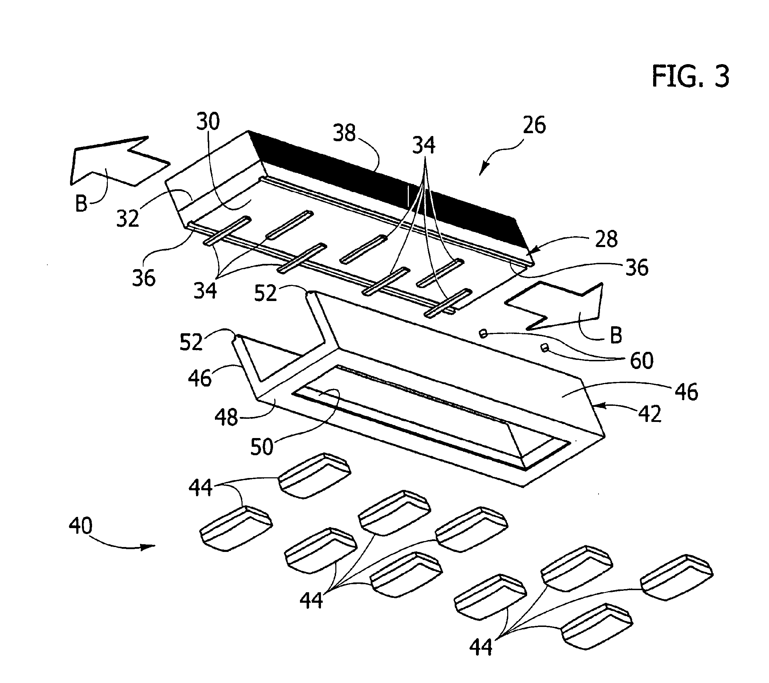

With reference to Figures 2 and 3, the receiver 26 comprises a base 28 of an elongated parallelepipedal shape having two principal plane faces 30, 32 opposite to one another. The base 28 is fixed between the side arms 24 that support the reflector 20.

Applied on the first face 30 of the base 28 is an array of strip-shaped targets 34. The targets 34 can be photovoltaic elements designed to convert solar radiation into electrical energy or else thermal absorbers designed to convert solar radiation into heat.

The targets 34 are in the form of thin parallelepipeds and are oriented in a direction orthogonal to the focal line A. The targets 34 are set at a distance apart from one another in a direction parallel to the focal line A. The distance between adjacent targets 34 is substantially greater than the width of each target 34.

Made on the first face 30 of the base 38 are two guides 36 parallel to the focusing line A and arranged on opposite sides of the array of targets 34. Preferably a thermal collector 38 is applied on the second face 32 of the base 28. In the case where the targets are formed by photovoltaic elements, the thermal collector is constituted, for example, by a finned body, designed to dissipate the heat produced by the receiver 26. In the case where the targets 34 are formed by thermal absorbers, the thermal collector 38 is formed by a duct for the passage of a diathermic fluid.

The solar receiver 26 comprises a focusing assembly 40, which comprises a support 42 and a plurality of optical elements 44. In the example illustrated in the drawings, the optical elements 44 are formed by cylindrical lenses. Alternatively, the optical elements could be formed by mirrors.

The support 42 has a shape elongated in the direction of the focal line A and is substantially U-shaped in cross section, with two side walls 46 set parallel to one another and a bottom wall 48. The bottom wall 48 has a through opening 50 of a flattened rectangular shape, in which the lenses 44 arranged in contact with one another are mounted.

Each lens 44 is set for focusing solar radiation onto a respective target 34. The side walls 46 of the lens support 42 have guides 52 that slidably engage the respective guides 36 of the base 28. Thanks to the engagement between the guides 36 and 52, the focusing assembly 40 is mobile with respect to the base 28 of the receiver 26 in a direction parallel to the focusing line A. In Figures 2 and 3, the direction of movement of the lens support 42 with respect to the base 28 is indicated by the arrows B.

With reference to Figure 1, the generator 10 comprises a zenithal-pointing device for varying the orientation of the reflector 20 as a function of the zenithal angle of the sun. The zenithal-pointing device comprises a photocell sensor 54 fixed with respect to the receiver 26 and to the reflector 20 and designed to detect the position of the sun. The photocell sensor 54 is, for example, fixed to one of the side arms 24. The zenithal-pointing device moreover comprises an electric motor 56 that governs rotation of the reflector 20 about the axis A as a function of the signals coming from the sensor 54. The zenithal-pointing device 54, 56 orients the reflector 20 according to the zenithal direction of the sun.

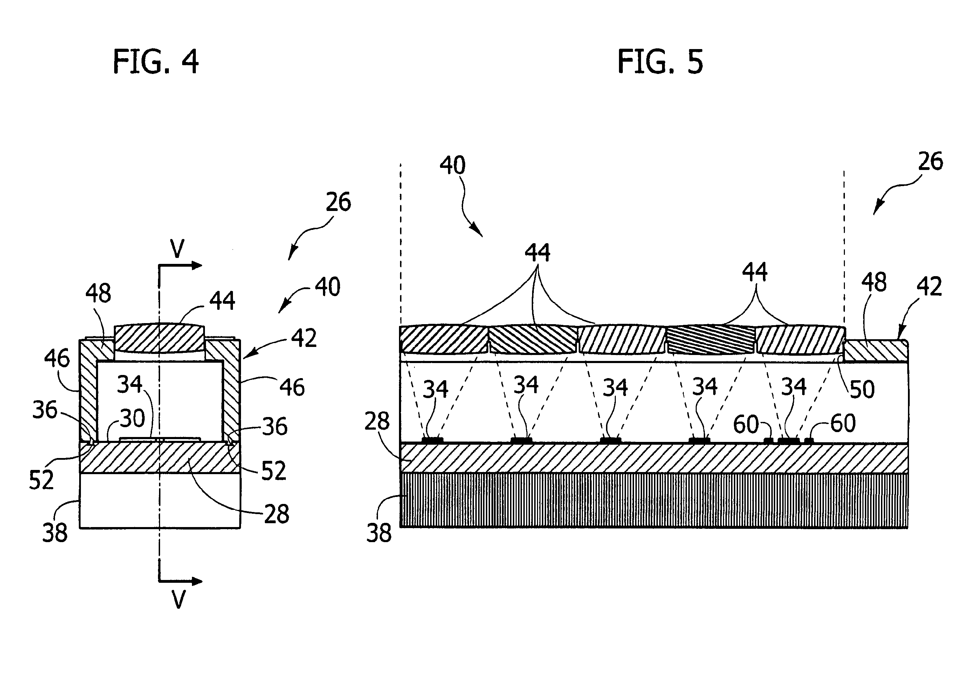

The receiver 26 comprises an azimuthal-pointing device including an actuator 58, designed to move the focusing assembly 40 with respect to the base 28 of the receiver 26. As illustrated in Figure 6, the actuator 58 can, for example, be set between one of the side arms 24 and the corresponding front end of the support 42. The actuator 58 is governed by a sensor designed to detect the azimuthal position of the sun. Said sensor may, for example, be made up of two photodiodes 60 (Figure 5) arranged on opposite sides of a target 34 in a direction parallel to the focal line A.

As illustrated schematically in Figure 5, the solar radiation reflected by the reflector 20 is concentrated on the lenses 44. Each lens 44 focuses the solar radiation onto a respective target 34. The actuator 58, on the basis of the signals coming from the photodiodes 60, moves the support 42 with respect to the base 28 of the receiver 26 so as to keep the radiation focused by the lenses 44 centred on the target 34. The movement of the focusing assembly 40 with respect to the base 28 replaces the azimuthal orientation of the reflector 20. It is possible to reduce the travel of the focusing assembly 40 with respect to the base 28 by controlling the movement of the focusing assembly 40 so that, when the distance between the centre of each lens 44 and the respective target 34 exceeds a pre-set value, the focusing assembly 40 is displaced in such a way that each lens 44 focuses the solar radiation on a target 34 adjacent to the target previously associated to the lens 44 in question.

The focusing assembly 40 enables considerable increase in the level of concentration of the solar radiation on the targets 34, which in turn enables high levels of efficiency to be obtained. In addition, the axial movement of the focusing assembly 40 replaces the azimuthal orientation of the reflector 20 and enables simplification of the structure and reduction of the cost of the generator 10.

The azimuthal tracking obtained by movement of the focusing assembly 40 moreover enables an improvement in exploitation of the surface available.

The solar concentrator associated to the receiver could form the subject of numerous variants with respect to what has been described previously. For example, the reflector 20, instead of being formed by a parabolic mirror that is able to turn about its own focusing axis, could be formed by a plurality of strip-shaped mirrors arranged parallel to the focusing line A in a way similar to what is described in the international patent application No. PCT/IT2008/000539.

## Claims

1. A solar receiver (26) for a linear-focusing solar concentrator defined a focal line (A), comprising:
- a base (28), which is elongated in a direction parallel to said focal line (A);
- an array of strip-shaped photoconversion or thermoconversion targets (34) mounted on the base (28), arranged orthogonal to said focal line (A) and set at a distance apart from one another in a direction parallel to said focal line (A);
- a focusing assembly (40) including an array of optical elements (44) arranged for focusing solar radiation on said strip-shaped targets (34),
**characterized in that**:
- said focusing assembly (40) is mobile with respect to the base (28) of the photovoltaic receiver (26) in a direction parallel to said focal line (A); and that
- the solar receiver comprises an azimuthal pointing device (58, 60), designed to move the focusing assembly (40) with respect to said base (28) in a direction parallel to said focal line (A) as a function of the position of the sun.

2. The solar receiver according to Claim 1,
**characterized in that** each of said optical elements (44) is associated to a respective strip-shaped target (34).

3. The solar receiver according to Claim 1 or
Claim 2, **characterized in that** said strip-shaped targets (34) are set at a distance apart from one another in a direction parallel to said focal line (A) by a distance substantially greater than the width of each strip-shaped target (34) in said direction.

4. The solar receiver according to Claim 1,
**characterized in that** said azimuthal pointing device comprises at least two photodetectors (60) fixed to the base (28) of the receiver (26) on opposite sides of a strip-shaped target (34) in a direction parallel to said focal line (A).

5. The solar receiver according to Claim 1,
**characterized in that** the base (28) has the shape of an elongated parallelepiped with two principal faces set parallel to one another (30, 32), on a first face (30) there being fixed strip-shaped photovoltaic targets (34) and on a second face (32) there being fixed a thermal collector (38) to dissipate the heat produced by the receiver (26).

6. The solar receiver according to Claim 1,
**characterized in that** the base (28) has the shape of an elongated parallelepiped with two principal faces set parallel to one another (30, 32), on a first face (30) there being fixed strip-shaped thermal absorbing targets (34) and on a second face (32) there being fixed an insulated thermal collector (38) that recovers heat.

7. The solar receiver according to Claim 1,
**characterized in that** said focusing assembly (40) comprises a support (42) carrying said optical elements (44) and slidably coupled to said base (28) by means of guides (36, 52).

## Patentansprüche

1. Sonnenempfänger (26) für einen Linearfokussierungs-Sonnenkonzentrator, der einen Brennlinie (A) definiert, umfassend:
- eine Grundplatte (28), die sich in einer Richtung parallel zur benannten Brennlinie (A) ausstreckt;
- eine Gruppe von streifenförmigen Photokonversions- oder Thermokonversionsauffängern (34), die an der Grundplatte (28) montiert, orthogonal zur benannten Brennlinie (A) angeordnet und in einer Richtung parallel zur benannten Brennlinie (A) voneinander beabstandet sind;
- eine Fokussierungsanordnung (40) umfassend eine Gruppe von optischen Elementen (44), die zur Fokussierung der Sonnenstrahlung auf den oben genannten streifenförmigen Auffängern (34) angeordnet sind,
**dadurch gekennzeichnet, dass**:
- die benannte Fokussierungsanordnung (40) gegenüber der Grundplatte (28) des Photovoltaikreceivers (26) in einer Richtung parallel zur benannten Brennlinie (A) beweglich ist; und dass
- der Sonnenempfänger eine Azimut-Ausrichtungsvorrichtung (58, 60) umfasst, die zur Bewegung der Fokussierungsanordnung (40) gegenüber der benannten Grundplatte (28) in einer Richtung parallel zur benannten Brennlinie (A) abhängig von der Sonnenlage vorgesehen ist.

2. Sonnenempfänger nach Anspruch 1, **dadurch gekennzeichnet, dass** jedes der benannten optischen Elemente (44) einem entsprechenden streifenförmigen Auffänger (34) zugeordnet ist.

3. Sonnenempfänger nach Anspruch 1 oder Anspruch 2, **dadurch gekennzeichnet, dass** die benannten streifenförmigen Auffänger (34) in einer Richtung parallel zur benannten Brennlinie (A) mit einem wesentlich höheren Abstand als der Breite jedes streifenförmigen Auffängers (34) in der benannten Richtung voneinander beabstandet sind.

4. Sonnenempfänger nach Anspruch 1, **dadurch gekennzeichnet, dass** die benannten Azimut-Ausrichtungsvorrichtung mindestens zwei Photodetektoren (60) umfasst, die an der Grundplatte (28) des Receivers (26) auf entgegengesetzten Seiten eines streifenförmigen Auffängers (34) in einer Richtung parallel zur benannten Brennlinie (A) befestigt sind.

5. Sonnenempfänger nach Anspruch 1, **dadurch gekennzeichnet, dass** die Grundplatte (28) als ein ausgestrecktes Parallelepipedon mit zwei zueinander parallelen Hauptflächen (30, 32) ausgebildet ist, wobei auf einer ersten Fläche (30) streifenförmige Photovoltaikauffänger (34) befestigt sind und auf einer zweiten Fläche (32) ein Wärmekollektor (38) zur Ableitung der durch den Receiver (26) erzeugten Wärme befestigt ist.

6. Sonnenempfänger nach Anspruch 1, **dadurch gekennzeichnet, dass** die Grundplatte (28) als ein ausgestrecktes Parallelepipedon mit zwei zueinander parallelen Hauptflächen (30, 32) ausgebildet ist, wobei auf einer ersten Fläche (30) streifenförmige wärmeaufnehmende Auffänger (34) befestigt sind und auf einer zweiten Fläche (32) ein isolierter Wärmekollektor (38) zur Wärmerückgewinnung befestigt ist.

7. Sonnenempfänger nach Anspruch 1, **dadurch gekennzeichnet, dass** die benannte Fokussierungsanordnung (40) einen Lager (42) umfasst, der die benannten optischen Elemente (44) trägt und mit der benannten Grundplatte (28) durch Führungen (36, 52) gleitend gekoppelt ist.

## Revendications

1. Récepteur solaire (26) pour un concentrateur solaire à focalisation linéaire définissant une ligne focale (A), comprenant:
- une base (28) s'allongeant dans une direction parallèle à ladite ligne focale (A);
- une série de cibles de photo-conversion ou thermo-conversion en forme de bande (34) montées sur la base (28), rangées orthogonalement à ladite ligne focale (A) et espacées l'une de l'autre dans une direction parallèle à ladite ligne focale (A);
- un ensemble de focalisation (40) comprenant une série d'éléments optiques (44) aptes à focaliser la radiation solaire sur lesdites cibles en forme de bande (34),
**caractérisé en ce que**:
- ledit ensemble de focalisation (40) est mobile par rapport à la base (28) du récepteur photovoltaïque (26) dans une direction parallèle à ladite ligne focale (A); et que
- le récepteur solaire comprend un dispositif de pointage azimutal (58, 60) destiné à déplacer l'ensemble de focalisation (40) par rapport à ladite base (28) dans une direction parallèle à ladite ligne focal (A) en fonction de la position du soleil.

2. Récepteur solaire selon la revendication 1, **caractérisé en ce que** chacun desdits éléments optiques (44) est associé à une cible en forme de bande (34) respective.

3. Récepteur solaire selon la revendication 1 ou la revendication 2, **caractérisé en ce que** lesdites cibles en forme de bande (34) sont espacées l'une de l'autre dans une direction parallèle à ladite ligne focale (A) par une distance substantiellement supérieure à la largeur de chaque cible en forme de bande (34) dans ladite direction.

4. Récepteur solaire selon la revendication 1, **caractérisé en ce que** ledit dispositif de pointage azimutal comprend au moins deux photo-détecteurs (60) fixés à la base (28) du récepteur (26) sur côtés opposés d'une cible en forme de bande (34) dans une direction parallèle à ladite ligne focale (A).

5. Récepteur solaire selon la revendication 1, **caractérisé en ce que** la base (28) a la forme d'un parallélépipède allongé avec deux faces principales parallèles l'une à l'autre (30, 32), sur une première face (30) étant fixé4s des cibles photovoltaïques en forme de bande (34) et sur une deuxième face (32) étant fixé un capteur thermique (38) pour dissiper la chaleur produite par le récepteur (26).

6. Récepteur solaire selon la revendication 1, **caractérisé en ce que** la base (28) a la forme d'un parallélépipède allongé avec deux faces principales parallèles l'une à l'autre (30, 32), sur une première face (30) étant fixées des cibles d'absorption thermique en forme de bande (34) et sur une deuxième face (32) étant fixé un capteur thermique isolé (38) récupérant la chaleur.

7. Récepteur solaire selon la revendication 1, **caractérisé en ce que** ledit ensemble de focalisation (40) comprend un support (42) pour lesdits éléments optiques (44) couplé de manière glissante à ladite base (28) au moyen de guides (36, 52).
